# FASCICULE DE BREVET EUROPEEN

(11) **EP 0 593 330 B1**
(45) Date de publication et mention de la délivrance du brevet: **09.12.1998**
(21) Numéro de dépôt: 93402405.0
(22) Date de dépôt: 01.10.1993
(51) Int. Cl.: H01L 25/10, H01L 25/065

(54) **Procédé d'interconnexion 3D de boîtiers de composants électroniques, et composant 3D en résultant**
3D-Verbindungsverfahren für Gehäuse von elektronischen Bauteilen und resultierendes 3D-Bauteil
3D-interconnection method for electronic component housings and resulting 3D component

(30) Priorité: 13.10.1992 FR 9212209
(43) Date de publication de la demande: 20.04.1994
(73) Titulaire: THOMSON-CSF, 75008 Paris (FR)
(72) Inventeur: Val Christian, F-92402 Courbevoie Cedex (FR)
(74) Mandataire: Guérin, Michel

(56) Documents cités:
- EP-A- 0 354 708
- EP-A- 0 478 188
- EP-A- 0 490 739
- WO-A-88/08203
- WO-A-92/03035
- US-A- 4 868 712

## Description

La présente invention a pour objet un procédé pour l'interconnexion de boîtiers empilés, chacun des boîtiers encapsulant un composant électronique discret, passif ou actif, ou intégré, pastille semi-conductrice contenant par exemple un circuit intégré, ou un ou plusieurs capteurs; ces composants seront désignés ci-après indifféremment par les termes composants ou pastilles. L'invention a également pour objet un composant dit trois dimensions, ou 3D, en résultant.

La réalisation des systèmes électroniques actuels, tant civils que militaires, doit tenir compte d'exigences de plus en plus grandes de compacité, du fait du nombre de plus en plus élevé de circuits mis en oeuvre. En ce sens, il a déjà été proposé de réaliser des empilements de circuits intégrés, comme par exemple décrit dans le brevet américain n° 4.706.166. Selon cette réalisation, les pastilles elles-mêmes sont disposées sur un circuit imprimé, accolées les unes aux autres perpendiculairement au circuit imprimé ; les plots de connexion de chacune des pastilles sont ramenés sur un même côté de la pastille ; ce côté est disposé sur le circuit imprimé et les connexions avec ce dernier y sont réalisées. Toutefois, cet arrangement présente notamment des limitations liées au nombre de plots qu'il est matériellement possible de disposer sur un seul côté d'une pastille semi-conductrice; en outre, il est onéreux du fait que les pastilles ne sont pas standard (la disposition des plots doit être modifiée) ; enfin, les connexions ainsi réalisées sont peu accessibles et de plus non visibles, ce qui est une nécessité dans certains domaines et, par suite, en limite l'utilisation.

Le brevet US 4 868 712, les demandes de brevet européen 354 708 et 490 739 et la demande de brevet internationale W0 88/08203 décrivent différentes techniques d'empilement 3D de pastilles semiconductrices.

La présente invention a pour objet d'éviter les limitations précédentes en empilant et en interconnectant non plus des pastilles, mais des boîtiers contenant les composants, les boîtiers étant montés sur des grilles, et en utilisant les faces de l'empilement comme surfaces d'interconnexion.

De la sorte, d'une part sont évités les inconvénients et limitations précédents et, d'autre part, le prix de revient en est diminué : en effet, notamment lorsqu'il s'agit de pastilles semi-conductrices, les pastilles sous boîtier, en plastique généralement, sont disponibles sur le marché à des prix inférieurs à ceux pratiqués pour les pastilles seules, principalement pour des raisons de quantités fabriquées, et leur test est en outre plus aisé donc moins onéreux. Enfin, le fait de monter les boîtiers chacun sur une grille permet de faciliter la formation de l'empilement et permet de constituer un drain thermique.

Plus précisément, l'invention a pour objet un procédé d'interconnexion tel que défini par la revendication 1, ainsi qu'un dispositif comportant des boîtiers tel que défini par la revendication 9.

D'autres objets, particularités et résultats de l'invention ressortiront de la description suivante, donnée à titre d'exemple et illustrée par les dessins annexés, qui représentent :
- la figure 1, un mode de réalisation du procédé selon l'invention ;
- la figure 2, un exemple de boîtier susceptible d'être inséré dans le dispositif selon l'invention ;
- les figures 3a à 3d, différentes variantes d'une étape de la fabrication du dispositif selon l'invention ;
- la figure 4, une étape suivante de la fabrication du dispositif selon l'invention ;
- la figure 5, une étape suivante de la fabrication du dispositif selon l'invention ;
- la figure 6, une étape suivante de la fabrication du dispositif selon l'invention ;
- la figure 7, une variante de la figure précédente ;
- la figure 8, une vue partielle d'un mode de réalisation du dispositif selon l'invention ;
- les figures 9a et 9b, des détails de réalisation de la figure précédente;
- la figure 10, un autre mode de réalisation du dispositif selon l'invention.

Sur ces différentes figures, les mêmes références se rapportent aux mêmes éléments. En outre, pour la clarté des dessins, l'échelle réelle n'a pas été respectée.

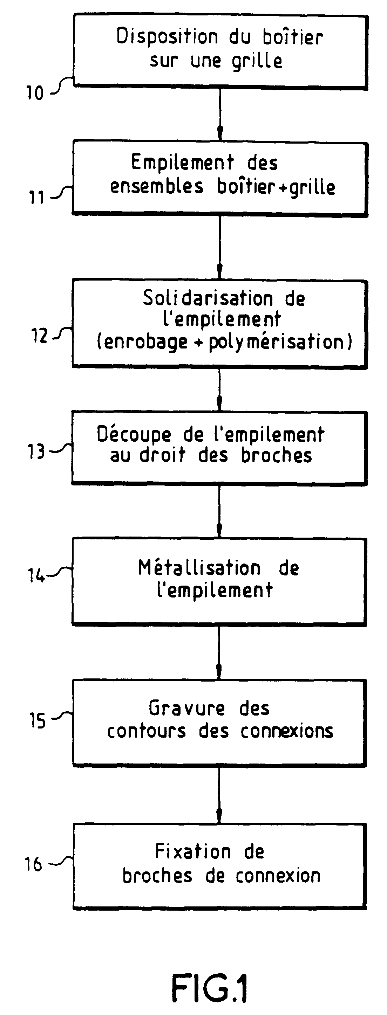

La figure 1 illustre donc un mode de réalisation du procédé selon l'invention.

La première étape du procédé, repérée 10, consiste à disposer un boîtier sur une grille de maintien dont les rôles sont précisés plus loin; le boîtier contient un composant électronique, par exemple une pastille semi-conductrice dans laquelle est réalisé un circuit intégré; il est en outre muni de broches de connexion.

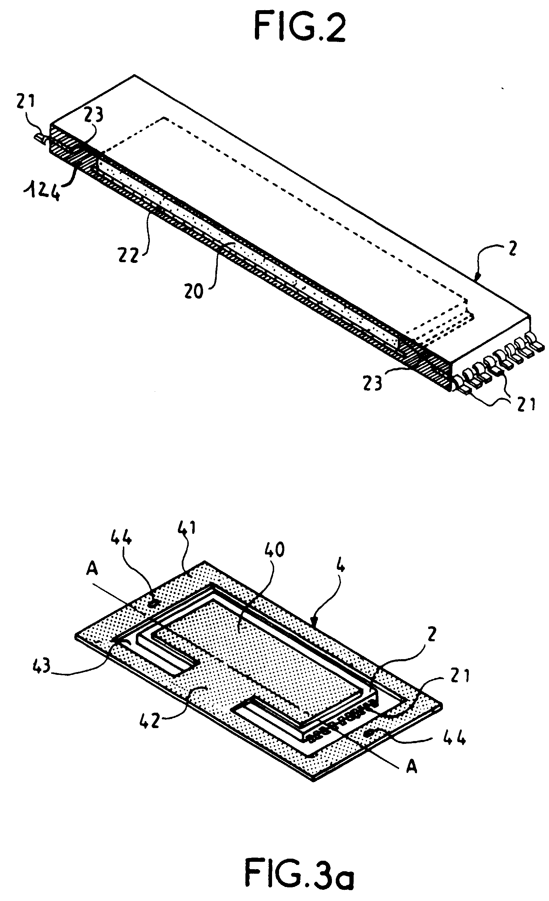

La figure 2 illustre un exemple d'un tel boîtier.

Sur cette figure, on a représenté un boîtier, globalement repéré 2, par exemple rectangulaire ; il comporte des broches de connexion 21 émergeant par exemple sur deux de ses côtés, par exemple les petits côtés. Une coupe a été réalisée dans le boîtier selon sa grande longueur; on y distingue la pastille 20, disposée en général sur une feuille électriquement conductrice 22, ainsi que deux broches 21 se prolongeant à l'intérieur du boîtier 2 et reliées par des fils conducteurs 23 aux plots de connexion (non représentés) de la pastille 20. Dans le mode de réalisation représenté, les différents éléments précédents sont noyés dans un matériau plastique 124 formant le boîtier, résine époxy par exemple. Le boîtier représenté peut être par exemple du type TSOP (pour Thin Small Outline Package).

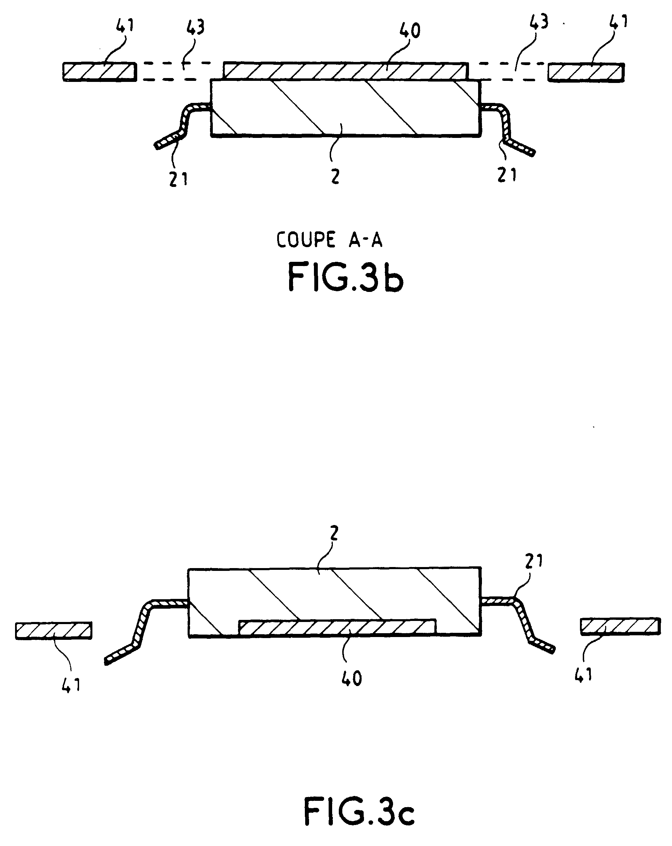

Lors de cette étape, les boîtiers sont donc montés chacun sur une grille comme illustré sur les figures 3a à 3d.

Sur la figure 3a, on retrouve le boîtier 2 muni de ses broches 21.

Sur une de ses faces, par exemple sa face supérieure, est fixée une feuille 4, appelée grille, par exemple sensiblement rectangulaire, comportant une partie centrale 40, un cadre 41 entourant la partie centrale mais séparé de celle-ci par une découpe 43, la partie centrale n'étant rattachée au cadre que par au moins une languette, 42 sur la figure dont la largeur peut atteindre sensiblement la longueur du boîtier 2. La partie centrale a, dans cet exemple de réalisation, une surface voisine de celle du boîtier 2, mais légèrement inférieure ; toutefois, les côtés de la partie centrale qui ne sont pas du côté des broches 21 peuvent s'étendre au-delà du boîtier 2. Le cadre 41 comporte en outre, de préférence, un ou plusieurs trous d'alignement 44. La grille 4 est fixée sur le boîtier 2 par exemple à l'aide d'une fine couche de colle dont l'épaisseur est de préférence sensiblement constante. Pour la clarté du schéma, la surface de la grille 4 a été pointillée. La grille 4 est réalisée de préférence en un matériau bon conducteur de la chaleur.

La figure 3b est une coupe réalisée selon un axe AA de la figure 3a, où on distingue le boîtier 2 muni par exemple sur sa face supérieure de la partie centrale 40, séparée du cadre 41 par la découpe 43.

La figure 3c représente, également vue en coupe, une variante de la figure 3b, dans laquelle la partie centrale 40 de la grille est placée dans une cavité ménagée à cet effet dans le boîtier 2, par exemple dans sa face inférieure.

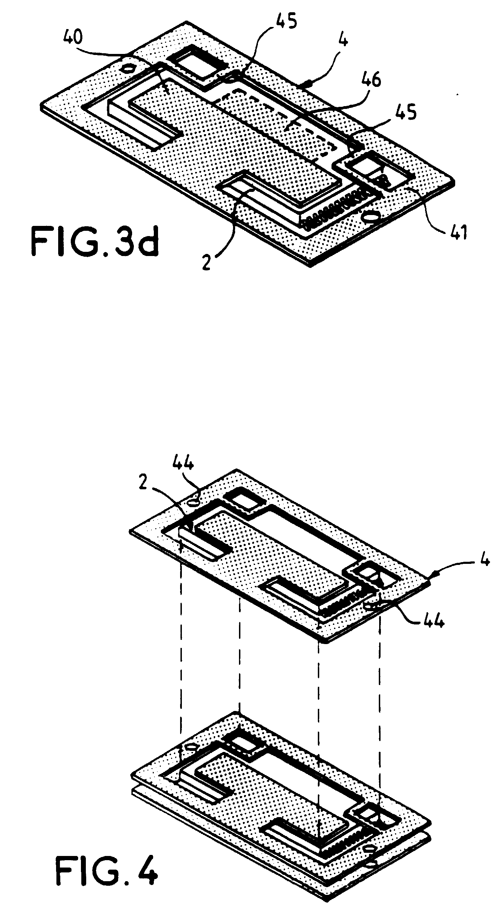

La figure 3d représente une variante de réalisation de la grille 4, dans laquelle celle-ci comporte en outre une ou plusieurs bandes 45, appelées connexions de renvoi, deux de ces connexions ayant été représentées sur la figure.

Ces connexions 45 relient entre elles deux côtés du cadre 41, par exemple selon un L, de sorte à passer au-dessus (ou en-dessous) du boîtier. Dans cette variante, le matériau constituant la grille doit être électriquement conducteur.

La surface de la partie centrale 40 se trouve alors un peu réduite, comme illustré par exemple sur la figure, avec une variante 46 en pointillés. Bien entendu, d'autres formes peuvent être adaptées pour la partie centrale ou les connexions de renvoi, sous réserve d'éviter tout contact entre partie centrale et connexions de renvoi.

L'étape d'après, repérée 11 sur la figure 1 et illustrée sur la figure 4, consiste à empiler les boîtiers 2 munis de leur grille 4, les uns sur les autres sans qu'il soit nécessaire de ménager un espace interboîtier, en utilisant pour cela de préférence les trous d'alignement 44. A titre d'exemple, les grilles utilisées sont du type décrit figure 3d.

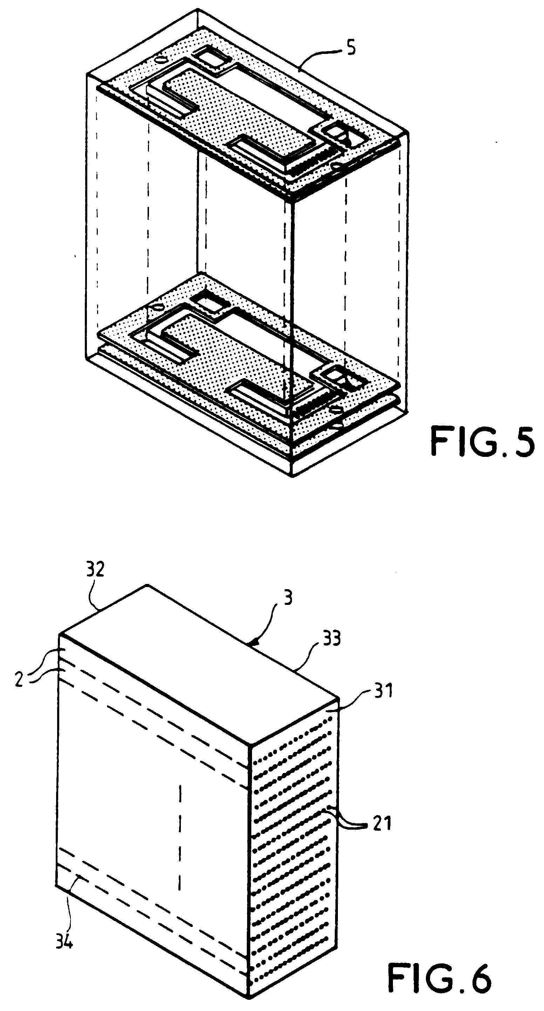

Lors de l'étape suivante, repérée 12 sur la figure 1 et illustrée sur la figure 5, on procède à la solidarisation de l'empilement par enrobage de l'ensemble par un matériau 5 électriquement isolant, tel qu'une résine polymérisable, époxy par exemple. Pour la clarté du dessin, les boîtiers 2 et grilles 4 n'ont pas été représentés en pointillés, bien que non visibles sur la figure 5.

L'étape suivante (13, figure 1) consiste à découper l'empilement au niveau de la découpe 43 de la grille, entre partie centrale 40 et cadre 41, de sorte à enlever le cadre et, dans un mode de réalisation préféré, à faire affleurer la partie centrale sur au moins une face de l'empilement, pour permettre à la grille de jouer un rôle de drain thermique, et découper les broches 21 des différents boîtiers en les laissant affleurer les faces de l'empilement.

La figure 6 représente le résultat de cette étape 13.

Sur cette figure sont visibles une face 31 sur laquelle affleurent les broches 21, la face supérieure 33 (parallèle aux boîtiers 2) et une face latérale 34 de l'empilement, repéré 3 ; les boîtiers 2 ont été représentés en pointillés.

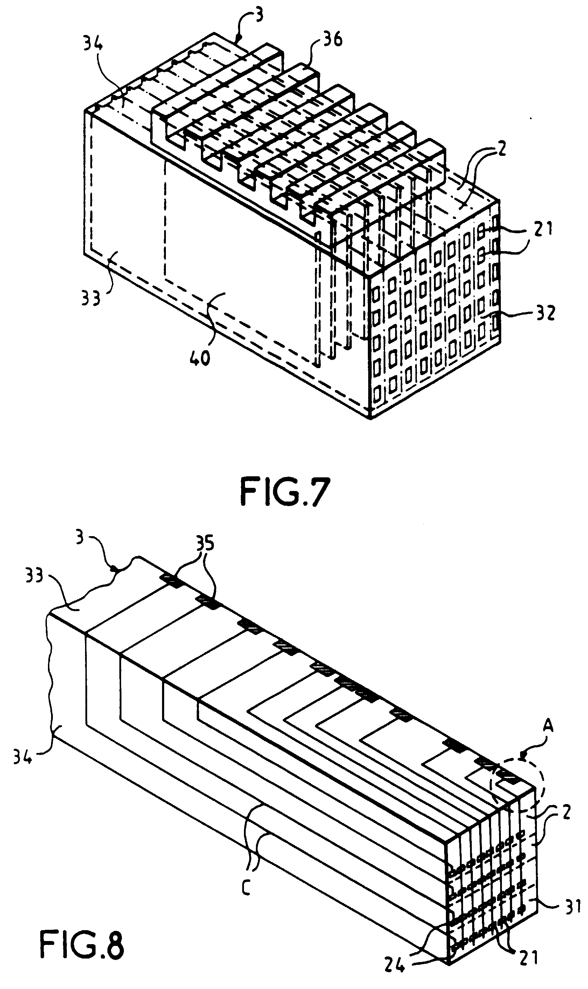

La figure 7 est une variante de la figure précédente, où on a disposé en outre un dissipateur thermique 36, par exemple un radiateur à ailettes, sur la face 34 de l'empilement 3 où affleurent les parties centrales 40 formant drains thermiques. Un dissipateur du même genre peut également être disposé sur la face de l'empilement qui est opposée à la face 34 et où les drains 40 peuvent également affleurer.

La fixation du radiateur 36 peut par exemple s'effectuer par collage, à l'aide d'une colle époxy par exemple, soit directement sur la face de l'empilement, soit après métallisation de celle-ci comme décrit ci-après.

L'étape suivante (14, figure 1) est, dans ce mode de réalisation, la première des étapes nécessaires à la réalisation de métallisations permettant d'interconnecter les broches 21. Elle consiste à déposer une (ou plusieurs) couche(s) conductrice(s), métallique(s) par exemple, sur l'ensemble des faces de l'empilement 3 précédemment réalisé.

L'étape suivante (15, figure 1) consiste à réaliser sur les faces de l'empilement 3, à partir de la couche métallique précédente, des connexions reliant les broches 21 entre elles.

La figure 8 est une vue fractionnaire d'un empilement selon l'invention, sur laquelle sont illustrés des exemples de connexion.

Sur cette figure, on a représenté l'empilement 3 dont les faces 31, 33 et 34 sont visibles. On a représenté également les boîtiers 2 en pointillés et leurs broches de connexion 21, affleurant la face 31. L'empilement 3 comporte sur une ou plusieurs de ses faces, par exemple sur la face 33, des plots 35, dits plots d'empilement, pour sa liaison électrique à des circuits extérieurs. Les broches 21 sont à la fois interconnectées entre elles et, quand nécessaire, reliées aux plots d'empilement 35 à l'aide de connexions C.

A titre d'exemple, on a représenté sur la figure le cas où les boîtiers 2 contiennent des mémoires ; dans ce cas, l'ensemble de leurs broches homologues sont reliées entre elles et à un plot d'empilement 35 sauf une, repérée 24, pour chacun des boîtiers. Cette broche 24, qui correspond à l'entrée de sélection de la mémoire, est reliée pour chaque boîtier individuellement à un plot d'empilement 35 distinct. Bien entendu, si les boîtiers comportent davantage de broches telles que 24, nécessitant une individualisation, on procède de même pour chacune.

Il apparaît toutefois que dans certains cas, les broches à individualiser, telles que 24, peuvent conduire à des difficultés de routage, notamment lorsqu'elles sont trop nombreuses.

Les connexions de renvoi 45 (figure 3d) qui peuvent être ménagées dans la grille 4 permettent de résoudre ce problème.

En effet, une telle connexion 45 peut être prévue sensiblement au droit d'une broche à individualiser ; lors de la découpe de l'empilement, elle est également découpée et affleure les faces de l'empilement ; elle est ensuite connectée à la broche à individualiser par une connexion C. On rappelle qu'elle relie deux faces distinctes de l'empilement : elle permet alors d'assurer le routage de la connexion de la broche à individualiser sur une autre face de l'empilement, de préférence libre de broches 21.

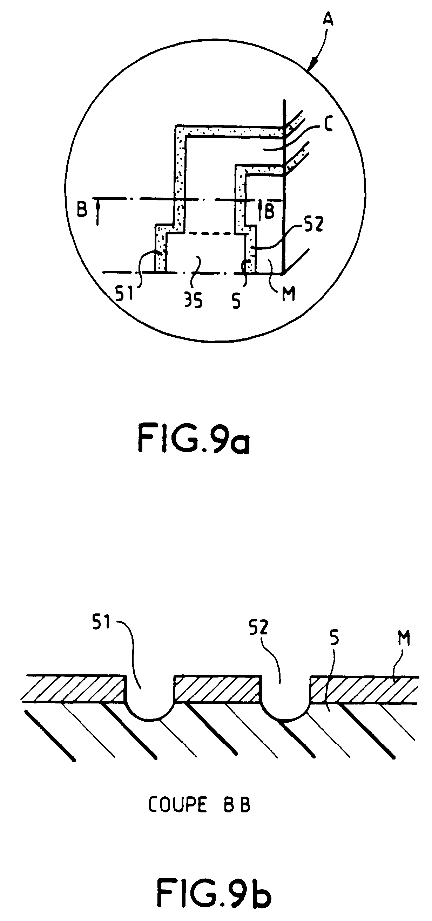

Les figures 9a et 9b illustrent plus en détail un mode de réalisation des connexions C.

La figure 9a représente une vue fractionnaire et agrandie d'un morceau A de l'empilement de la figure 8, où l'on voit une connexion C et un plot d'empilement 35. La figure 9b est une vue en coupe selon un axe BB de la figure 9a.

Chacune des connexions C est formée par deux gravures 51 et 52, réalisées à l'aide d'un laser qui détruit localement la couche conductrice, repérée M, et fait apparaître le matériau isolant 5 de solidarisation de l'empilement ; ce matériau 5 a été représenté en pointillés sur la figure 9a pour la clarté du schéma. De la sorte, on réalise l'isolation électrique de la connexion C du reste de la couche M. Les plots d'empilement 35 peuvent être avantageusement réalisés par la même technique de gravure laser comme représenté sur la figure 9a.

Une autre méthode de réalisation des connexions C consiste à réaliser d'abord des rainures dans le matériau d'enrobage de l'empilement 3, au niveau où les broches 21 affleurent, de sorte à dégager l'extrémité de ces dernières, et opérer ces rainures selon le dessin retenu pour les connexions C ; ces rainures peuvent être réalisées par laser ; puis on dépose une couche électriquement conductrice (métal par exemple) sur l'ensemble de l'empilement, faces et rainures ; enfin, on enlève la couche conductrice des surfaces planes de l'empilement (par polissage ou par laser par exemple), de sorte à ne la laisser subsister que dans les rainures où elle réalise les connexions recherchées.

D'autres méthodes de réalisation des connexions C sont bien entendu possibles, comme la photolithogravure par exemple.

Il est à noter que les connexions C et les plots d'empilement 35 peuvent être disposés sur des faces quelconques de l'empilement ou même la totalité des faces, le choix se faisant en fonction de l'application.

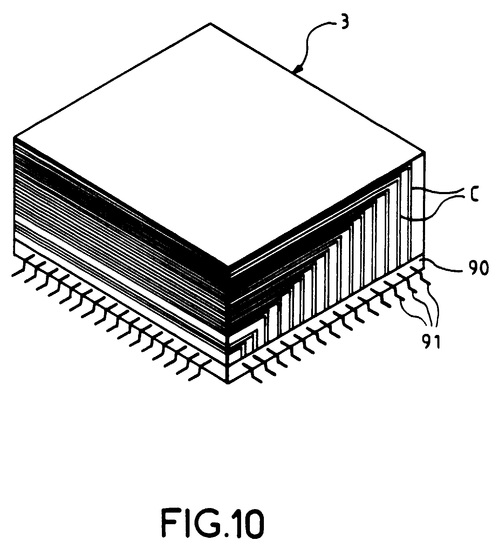

La dernière étape du procédé représenté figure 1, repérée 16, consiste, en tant que besoin, en la fixation sur l'empilement de broches de connexion, comme illustré sur la figure 10.

Sur cette figure, on retrouve l'empilement 3 et, à titre d'exemple, des connexions C reliant des broches 21 (non représentées) aux plots d'empilement ; toutefois, ceux-ci ne sont pas ici visibles parce que tous disposés dans cet exemple sur la face inférieure de l'empilement. Les plots d'empilement sont recouverts par un anneau 90 électriquement isolant portant des broches de connexion 91. L'anneau 90, obtenu par moulage par exemple, a sensiblement les mêmes dimensions extérieures que l'empilement 3 et lui est collé. Les broches 91 traversent l'anneau pour venir affleurer sa face supérieure, en vis-à-vis des plots d'empilement. Une soudure, plomb-étain par exemple, est disposée sur les broches 91 ou sur les plots d'empilement préalablement au collage de l'anneau. Après collage, la soudure est refondue, par exemple à l'aide d'un laser à travers l'anneau, pour assurer la connexion électrique plots-broches.

Cette dernière étape est optionnelle. En effet, un empilement 3 n'est pas nécessairement muni de broches de connexion : il peut être monté par soudure directe sur ses plots d'empilement, sur un circuit imprimé ou sur un autre empilement. Il peut encore être muni classiquement de broches de connexion destinées à traverser les trous métallisés d'un circuit imprimé.

Il a été ainsi décrit un dispositif d'interconnexion en trois dimensions de boîtiers contenant des composants électroniques, qui présente globalement de nombreux avantages :
- permettre une densité de composants élevée : en effet, les boîtiers sont ici empilés et, ce, sans espacement entre les boîtiers ;
- être utilisable avec des boîtiers présentant des broches de connexion sur un nombre quelconque de côtés : en effet, l'invention ne nécessite pas qu'une ou deux des faces latérales soient libres de broches :
- être applicable à l'empilement d'un nombre quelconque de boîtiers ;
- présenter un coût de production bas, notamment parce qu'il se prête à l'utilisation des boîtiers à leur sortie du moule, lorsqu'ils sont encore reliés en barrettes : les barrettes sont alors empilées comme décrit ci-dessus pour les boîtiers et plusieurs empilements peuvent être ainsi réalisés collectivement.

En outre, le fait de fixer une grille sur les boîtiers avant empilement permet de disposer d'un support commode pour réaliser et centrer l'empilement, d'incorporer à l'empilement un drain thermique et enfin, d'ajouter une liberté supplémentaire au routage des connexions sur les surfaces de l'empilement, grâce aux connexions de renvoi qu'on peut former sur la grille.

Différentes variantes de la description faite ci-dessus sont possibles. C'est ainsi qu'on a illustré sur les figures l'empilement de boîtiers ayant sensiblement la même taille mais ceci n'est pas nécessaire: lorsque les boîtiers sont de dimensions différentes, l'invention s'applique sous réserve de mettre tous les boîtiers aux cotes du plus grand, à l'aide pour chacun d'un support du type circuit imprimé sur lequel le boîtier est connecté, ce circuit imprimé pouvant être multicouche, facilitant ainsi le routage des connexions.

## Revendications

1. Procédé d'interconnexion en trois dimensions de boîtiers contenant au moins un composant électronique et munis de broches de connexion, comportant les étapes suivantes :
- fixation (10) de chacun des boîtiers (2) sur une feuille appelée grille (4), assurant le support du boîtier ;
- empilement (11) des boîtiers avec leurs grilles ;
- enrobage (12) des boîtiers et des grilles empilés à l'aide d'un matériau (5) électriquement isolant;
- découpe (13) de l'empilement au droit des broches (21) des boîtiers, de sorte qu'elles affleurent les faces de l'empilement ;
- formation (15) de connexions électriques (C) entre les broches sur les faces de l'empilement, les connexions (C) étant obtenues à l'aide de couches conductrices déposées sur les dites faces.

2. Procédé selon la revendication 1, caractérisé par le fait que le matériau isolant (5) est une résine polymérisable.

3. Procédé selon l'une des revendications précédentes, caractérisé par le fait que la grille (4) comporte une partie centrale (40) reliée à un cadre (41) par au moins une languette (42), l'opération de découpe étant réalisée de sorte que le cadre soit retiré et que la partie centrale et/ou la languette affleurent les faces de l'empilement, le matériau formant la grille étant thermiquement conducteur.

4. Procédé selon la revendication 3, caractérisé par le fait que le cadre (41) comporte des trous d'alignement (44) permettant l'alignement des boîtiers lors de l'étape d'empilement.

5. Procédé selon la revendication 3, caractérisé par le fait que la grille (4) comporte en outre au moins une bande (45) dite connexion de renvoi, reliant entre eux deux côtés du cadre (41) de sorte à passer au-dessus ou au-dessous du boîtier (2), le matériau de la grille étant en outre électriquement conducteur.

6. Procédé selon l'une des revendications précédentes, caractérisé par le fait que l'étape de formation des connexions électriques (C) se décompose en deux sous-étapes :
- la première sous-étape consistant en un dépôt d'une couche conductrice sur l'ensemble des faces de l'empilement ;
- la deuxième sous-étape consistant en une gravure à l'aide d'un laser de la couche conductrice pour former des connexions électriques reliant les broches entre elles.

7. Procédé selon l'une des revendications précédentes, caractérisé par le fait que, lors de l'étape de formation de connexions électriques, sont formés en outre des plots dits d'empilement, destinés à la connexion de l'empilement avec des circuits extérieurs, et que les connexions électriques relient entre elles au moins certaines des broches et les plots d'empilement.

8. Procédé selon l'une des revendications précédentes, caractérisé par le fait qu'il comporte en outre, après l'étape de formation (15) de connexions électriques, une étape de fixation sur l'empilement de broches de connexion (91).

9. Dispositif comportant des boîtiers (2) contenant chacun au moins un composant électronique (20), les boîters étant munis de broches de connexion (21), le dispositif étant caractérisé par le fait que les boîtiers sont solidaires chacun d'une feuille appelée grille (4), qu'ils sont disposés les uns au-dessus des autres et que le dispositif comporte un matériau isolant (5) enrobant et solidarisant les boîtiers empilés, que les broches des boîtiers affleurent les faces de l'empilement et que des connexions (C) entre les broches sont déposées sur les faces de l'empilement.

10. Dispositif selon la revendication 9 caractérisé par le fait que le matériau formant la grille est thermiquement conducteur et que les grilles affleurent les faces de l'empilement, étant ainsi susceptibles de former un drain thermique.

11. Dispositif selon l'une des revendications 9 ou 10 caractérisé par le fait que la grille est réalisée en matériau électriquement conducteur, qu'elle comporte en outre au moins une bande dite connexion de renvoi (45), reliant entre elles deux faces de l'empilement, et que la connexion de renvoi est reliée à une broche d'un boîtier par une connexion (C).

## Claims

1. Method for interconnection, in three dimensions, of packages which contain at least one electronic component and are provided with connection pins, including the following steps:
- fixing (10) each of the packages (2) on a so-called grid sheet (4) which supports the package;
- stacking (11) the packages with their grids;
- encapsulating (12) the stacked packages and grids using an electrically insulating material (5);
- cutting (13) the stack at the pins (21) of the packages, so that they are flush with the faces of the stack;
- forming (15) electrical connections (C) between the pins on the faces of the stack, the connections (C) being obtained with the aid of conductive layers deposited on the said faces.

2. Method according to Claim 1, characterized in that the insulating material (5) is a polymerizable resin.

3. Method according to one of the preceding claims, characterized in that the grid (4) has a central part (40) connected to a frame (41) by at least one tongue (42), the cutting operation being carried out in such a way that the frame is withdrawn and the central part and/or the tongue are flush with the faces of the stack, the material forming the grid being thermally conductive.

4. Method according to Claim 3, characterized in that the frame (41) has alignment holes (44) allowing the packages to be aligned during the stacking step.

5. Method according to Claim 3, characterized in that the grid (4) furthermore includes at least one so-called return connection strip (45) connecting together two sides of the frame (41) so as to pass above or below the package (2), the material of the grid being furthermore electrically conductive.

6. Method according to one of the preceding claims, characterized in that the step of forming the electrical connections (C) is divided into two sub-steps:
- the first sub-step consisting in depositing a conductive layer on all the faces of the stack;
- the second sub-step consisting in using a laser to etch the conductive layer in order to form electrical connections joining the pins to one another.

7. Method according to one of the preceding claims, characterized in that, during the step of forming electrical connections, so-called stack pads are furthermore formed which are intended to connect the stack to external circuits, and in that the electrical connections join together at least some of the pins and the stack pads.

8. Method according to one of the preceding claims, characterized in that, after the step of forming (15) electrical connections, it furthermore includes a step of fixing connection pins (91) on the stack.

9. Device including packages (2) which each contain at least one electronic component (20), the packages being provided with connection pins (21), the device being characterized in that the packages are each secured to a so-called grid sheet (4), in that they are arranged above one another and in that the device includes an insulating material (5) encapsulating and securing the stacked packages, in that the pins of the packages are flush with the faces of the stack and in that connections (C) between the pins are arranged on the faces of the stack.

10. Device according to Claim 9, characterized in that the material forming the grid is thermally conductive and in that the grids are flush with the faces of the stack, thus being capable of forming a heat sink.

11. Device according to either of Claims 9 and 10, characterized in that the grid is made of an electrically conductive material, in that it furthermore includes at least one so-called return connection strip (45) connecting together two faces of the stack, and in that the return connection is connected to a pin of a package by a connection (C).

## Patentansprüche

1. Dreidimensionales Verbindungsverfahren für Gehäuse, die mindestens ein elektronisches Bauelement enthalten und Anschlußfahnen besitzen, wobei das Verfahren die folgenden Schritte aufweist:
- Befestigung (10) jedes der Gehäuse auf einer Gitter genannten Folie (4), die als Träger für das Gehäuse wirkt,
- Stapelung (11) der Gehäuse mit ihren Gittern,
- Umhüllung (12) der gestapelten Gehäuse und Gitter mit einem elektrisch isolierenden Material (5),
- Zerschneiden (13) des Stapels vor den Anschlußfahnen (21) der Gehäuse, sodaß diese an den Seiten des Stapels zutage treten,
- Bildung (15) von elektrischen Verbindungen (C) zwischen den Anschlußfahnen auf den Seiten des Stapels, wobei die Verbindungen (C) mithilfe von leitenden Schichten erhalten werden, die auf die Seiten aufgebracht werden.

2. Verfahren nach Anspruch 1, dadurch gekennzeichnet, daß das isolierende Material (5) ein polymerisierbares Harz ist.

3. Verfahren nach einem der vorhergehenden Ansprüche, dadurch gekennzeichnet, daß das Gitter (4) einen zentralen Bereich (40) und einen daran über mindestens eine Zunge (42) angeschlossenen Rahmen (41) enthält, wobei das Zerschneiden so erfolgt, daß der Rahmen entfernt wird und daß der zentrale Bereich und/oder die Zunge an den Seiten des Stapels zutage treten, und wobei das Material des Gitters ein wärmeleitendes Material ist.

4. Verfahren nach Anspruch 3, dadurch gekennzeichnet, daß der Rahmen (41) Löcher (44) zum Ausrichten der Gehäuse während des Stapelns aufweist.

5. Verfahren nach Anspruch 3, dadurch gekennzeichnet, daß das Gitter (4) außerdem mindestens ein sogenanntes Umlenkverbindungsband (45) enthält, das zwei Seiten des Rahmens (41) miteinander verbindet, sodaß die Verbindung über oder unter das Gehäuse (2) verläuft, wobei das Material des Gitters außerdem elektrisch leitend ist.

6. Verfahren nach einem der vorstehenden Ansprüche, dadurch gekennzeichnet, daß der Schritt der Bildung der elektrischen Verbindungen (C) aus zwei Teilschritten besteht, nämlich
- dem ersten Teilschritt, bei dem eine leitende Schicht auf alle Seiten des Stapels aufgebracht wird,
- und dem zweiten Teilschritt, bei dem mithilfe eines Lasers die leitende Schicht graviert wird, sodaß elektrische Verbindungen zwischen den Anschlußfahnen entstehen.

7. Verfahren nach einem der vorstehenden Ansprüche, dadurch gekennzeichnet, daß bei dem Schritt der Bildung der elektrischen Verbindungen außerdem Stapelanschlußpunkte gebildet werden, die zur Verbindung des Stapels mit äußeren Schaltkreisen bestimmt sind, und daß die elektrischen Verbindungen zumindest bestimmte des Anschlußfahnen mit den Stapelanschlußpunkten verbinden.

8. Verfahren nach einem der vorstehenden Ansprüche, dadurch gekennzeichnet, daß außerdem nach der Bildung (15) von elektrischen Verbindungen ein Verfahrensschritt vorgesehen ist, bei dem Anschlußstifte (91) am Stapel befestigt werden.

9. Vorrichtung mit Gehäusen (2), die je mindestens ein elektronisches Bauteil (20) enthalten und Anschlußfahnen (21) besitzen, dadurch gekennzeichnet, daß die Gehäuse mit einer Gitter (4) genannten Folie fest verbunden werden, daß sie übereinander angeordnet sind und daß die Vorrichtung ein isolierendes Material (5) enthält, das die gestapelten Gehäuse umgibt und den Stapel einpackt, daß die Anschlußfahnen der Gehäuse an den Seiten des Stapels zutage treten und daß die Verbindungen (C) zwischen den Anschlußfahnen auf die Seiten des Stapels aufgebracht sind.

10. Vorrichtung nach Anspruch 9, dadurch gekennzeichnet, daß das Material des Gitters wärmeleitend ist und daß die Gitter an den Seiten des Stapels zutage traten und so Wärmeableiter bilden können.

11. Vorrichtung nach einem der Ansprüche 9 oder 10, dadurch gekennzeichnet, daß das Gitter aus einem elektrisch leitenden Material besteht und außerdem mindestens ein Umlenkverbindungsband (45) enthält, das zwei Seiten des Stapels miteinander verbindet, und daß die Umlenkverbindung an eine Anschlußfahne eines Gehäuses über eine Verbindung (C) angeschlossen ist.
